# EUROPÄISCHE PATENTSCHRIFT

(11) **EP 2 546 669 B1**
(45) Veröffentlichungstag und Bekanntmachung des Hinweises auf die Patenterteilung: **30.11.2016**
(21) Anmeldenummer: 12004923.4
(22) Anmeldetag: 02.07.2012
(51) Int. Cl.: G01R 33/00, G01R 33/07, G01R 33/02, G01R 33/022

(54) **Magnetfeldsensor und Verfahren zur Bestimmung der Offsetspannung eines Magnetfeldsensors**
Magnetic field sensor and method for determining the offset voltage of a magnetic field sensor
Capteur de champ magnétique et procédé de détection de la tension offset d'un capteur de champ magnétique

(30) Priorität: 14.07.2011 DE 102011107711
(43) Veröffentlichungstag der Anmeldung: 16.01.2013
(73) Patentinhaber: Micronas GmbH, 79108 Freiburg (DE); Albert-Ludwigs-Universität Freiburg, 79104 Freiburg (DE)
(72) Erfinder: Kaufmann, Timo, 79183 Waldkirch-Suggental (DE); Raz, Roiy, 79106 Freiburg (DE); Ruther, Patrick, 76199 Karlsruhe (DE); Paul, Oliver, 79280 Au (DE)
(74) Vertreter: Koch Müller Patentanwaltsgesellschaft mbH

(56) Entgegenhaltungen:
- US-A1- 2008 265 880
- US-A1- 2010 164 491
- US-B1- 6 768 301

## Beschreibung

Die Erfindung betrifft einen Magnetfeldsensor gemäß dem Oberbegriff des Patentanspruchs 1 und ein Verfahren zur Bestimmung und Korrektur einer Offsetspannung eines Magnetfeldsensors gemäß dem Oberbegriff des Patentanspruchs 12.

Aus der DE 10 150 955 C1 ist ein Magnetfeldsensor bekannt. Der Magnetfeldsensor weist mehrere Hallsensoren mit jeweils fünf Anschlusskontakten auf. Hierbei sind die bis zu vier Hallsensoren parallel zueinander ausgebildet und die Anschlusskontakte mittels einer zyklischen Vertauschung miteinander verschaltet. Des Weiteren sind aus der US 2010 / 0123458 A1 und aus "Kejk, P., Reymond, S., Popovic, R.S.: Cicular Hall Transducer for Angular Position Sensing. In: Transducers & Eurosensors ,07, 14th Conf. Solid-State Sensors, Actuators and Microsystems, 2007, S. 2593-2596." weitere Hallsensoren bekannt. Hierbei wird bei der letztgenannten Druckschrift eine kreisförmige Anordnung mit einer Vielzahl Hallsensoren mit einzelnen Hallkontakten offenbart. Mittels einer Steuereinheit werden jeweils fünf Kontakte aus einer Vielzahl von Hallsensorkontakten ausgewählt, um einen virtuellen Fünf-Kontakthallsensor zu erzeugen. Mittels der Ansteuerung lassen sich in zeitlicher Folge nacheinander andere Hallkontakte auf der kreisförmigen Anordnung auswählen, so dass der virtuelle gebildete Hallsensor auf dem Kreis quasi rotiert. Eine ähnliche Ausführungsform ist aus der US 2010 / 0164 4491 A1 bekannt. Weitere Hallsensoranordnungen geeignet auch zur Offsetkompensation sind aus DE 199 43 128 A1 bzw. der US 6 768 301 B1 und der US 2008 / 0265 880 A1 bekannt.

Vor diesem Hintergrund besteht die Aufgabe der Erfindung darin, eine Vorrichtung anzugeben, die den Stand der Technik weiterbildet.

Die Aufgabe wird jeweils durch einen Magnetfeldsensor mit den Merkmalen des Patentanspruchs 1 und durch ein Verfahren gemäß dem Oberbegriff des Patentanspruchs 12 gelöst. Vorteilhafte Ausgestaltungen der Erfindung sind Gegenstand von Unteransprüchen.

Gemäß dem ersten Gegenstand der Erfindung wird ein Magnetfeldsensor bereitgestellt, aufweisend einen Hallsensor mit einem ersten Anschlusskontakt und mit einem zweiten Anschlusskontakt und mit einem dritten Anschlusskontakt und mit einem vierten Anschlusskontakt und mit einem fünften Anschlusskontakt, wobei zwischen dem ersten Anschlusskontakt und dem fünften Anschlusskontakt ein erster Schalter mit einem Steuerungseingang vorgesehen Ist und der erste Schalter den ersten Anschlusskontakt mit dem fünften Anschlusskontakt verbindet oder voneinander trennt, und eine Steuerungseinheit vorgesehen Ist und die Steuerungseinheit mit dem Steuerungseingang des ersten Schalters verbunden ist. Es sei angemerkt, dass es sich vorliegend bei dem Magnetfeldsensor insbesondere um einen elektrisch isolierten Hallsensor handelt, der als einzelner separater Hallsensor ausgebildet Ist. Ein derartiger Hallsensor ist vorzugsweise als Halbleiterbauteil in einer elektrisch isolierten Wanne ausgebildet und besitzt insbesondere außer den genannten Anschlusskontakten keine weiteren Anschlusskontakte.

Gemäß dem zweiten Gegenstand der Erfindung wird ein Verfahren zur Bestimmung und Korrektur einer Offsetspannung eines Magnetfeldsensors bereitgestellt, aufweisend einen vertikalen Hallsensor mit einem ersten Anschlusskontakt und mit einem zweiten Anschlusskontakt und mit einem dritten Anschlusskontakt und mit einem vierten Anschlusskontakt und mit einem fünften Anschlusskontakt, wobei eine Steuerungseinheit und ein erster Schalter mit einem Steuerungseingang zwischen dem ersten Anschlusskontakt und dem fünften Anschlusskontakt vorgesehen ist und In einem ersten Zustand mittels der Steuerungseinheit der Steuerungseingang des Schalters angesteuert wird und die Offsetspannung des Hallsensors bestimmt wird, wobei mittels des ersten Schalters der erste Anschlusskontakt von dem fünften Anschlusskontakt getrennt wird und in einem zweiten Zustand mittels des ersten Schalters der erste Anschlusskontakt mit dem fünften Anschlusskontakt verbunden wird und eine mit der Offsetspannung beaufschlagte Hallspannung gemessen wird und die gemessene Hallspannung um die Offsetspannung korrigiert wird.

Ein Vorteil der erfindungsgemäßen Vorrichtung und des Verfahrens ist es, dass sich durch die erfindungsgemäße Verschaltung und mittels der Berücksichtigung der Widerstände zwischen den einzelnen Kontakten eine, um eine Offsetspannung, reduzierte Hallspannung ermitteln lässt. Hierdurch wird das Signal-zu-Offset-Verhältnis des Magnetfeldsensors bzw. des Hallsensors erhöht, d.h. die Hallspannung lässt sich weitestgehend offsetfrei bestimmen. Besonders vorteilhaft ist, dass sich die Bestimmung der Offsetspannung sowohl in Anwesenheit als auch in Abwesenheit eines Magnetfelds durchführen lässt. Hierdurch lässt sich das erfindungsgemäße Verfahren zur Bestimmung der Stärke eines Magnetfeldes vorteilhaft verwenden. Weiterhin Ist vorteilhaft, dass sich das Verfahren und die Vorrichtung auch in einem großen Temperaturbereich, vorzugsweise zwischen -40°C und 170°C einsetzen lässt.

In einer bevorzugten Ausführungsform sind alle Anschlusskontakte in einer Reihe angeordnet, wobei der erste Anschlusskontakt des Hallsensors als Anfangskontakt und der fünfte Anschlusskontakt als Endkontakt der Reihe ausgebildet ist. Gemäß einer anderen Ausführungsform bilden der erste Anschlusskontakt und der fünfte Anschlusskontakt jeweils außenliegende Anschlusskontakte aus, sodass die weiteren Anschlusskontakte zwischen dem ersten Anschlusskontakt und dem fünften Anschlusskontakt ausgebildet sind.

In einer Weiterbildung besteht der erste Schalter aus einem zweiten Schalter und einem dritten Schalter und der zweite Schalter und der dritte Schalter miteinander in Serie verschaltet sind und der zweite Schalter mit einem Steuerungseingang mit der Steuerungseinheit und der dritte Schalter mit einem Steuerungseingang mit der Steuerungseinheit verschaltet sind.

In einer anderen Weiterbildung ist der erste Anschlusskontakt und der zweite Anschlusskontakt und der dritte Anschlusskontakt und der vierte Anschlusskontakt und der fünfte Anschlusskontakt mit der Steuerungseinheit verschaltet. Ein Vorteil ist, dass mittels der Steuerungseinheit die Anschlusskontakte sich mit einer Spannungsquelle oder einer Stromquelle verbinden und hierdurch unterschiedlich ansteuern lassen.

In einer anderen Weiterbildung Ist die Steuerungseinheit eingerichtet, zur Bestimmung der Offsetspannung in einem ersten Zustand mittels des ersten Schalters oder der mittels des zweiten Schalters und des dritten Schalters den ersten Anschlusskontakt von dem fünften Anschlusskontakt zu trennen und in einem zweiten Zustand zur Messung einer mit der Offsetspannung beaufschlagten Hallspannung mittels des Schalters den ersten Anschlusskontakt mit dem fünften Anschlusskontakt zu verbinden. Insbesondere werden in dem ersten Zustand die Widerstände jeweils zwischen zwei benachbarten Anschlusskontakten bestimmt. Vorzugsweise werden zur Bestimmung der Widerstände zwischen den Anschlusskontakten die Anschlusskontakte mit unterschiedlichen Spannungshöhen beaufschlagt. Mittels der gemessenen Widerstandswerte unter Zugrundlegung eines Ersatzschaltbildes wird die der Hallspannung überlagerte Offsetspannung ermittelt.

Gemäß einer anderen Ausführungsform werden mittels einer Umschaltmethode, d.h. "switching-current"-Methode, vier um die jeweilige Offsetspannung korrigierte Hallspannungen ermittelt und aus den vier Hallspannungen eine mittlere Hallspannung bestimmt. Untersuchungen haben gezeigt, dass sich ein Hallsensor mit insgesamt fünf Kontakten in vier unterschiedlichen Moden betreiben lässt, wobei in einem ersten Modus und zweiten Modus der erste Anschlusskontakt und der fünfte Anschlusskontakt mit einer ersten Referenzspannung beaufschlagt werden und gleichzeitig der dritte Anschlusskontakt mit einer zweiten Referenzspannung beaufschlagt wird. Hierbei wird an dem zweiten Anschlusskontakt und an dem vierten Anschlusskontakt die Hallspannung abgegriffen. Entsprechend wird in einem dritten Modus und einem vierten Modus an dem ersten Anschlusskontakt, an dem fünften Anschlusskontakt und an dem dritten Anschlusskontakt die Hallspannung abgegriffen. Hierzu wird der zweite Anschlusskontakt mit einer ersten Referenzspannung beaufschlagt und der vierte Anschlusskontakt mit einer zweiten Referenzspannung beaufschlagt.

Vorzugsweise werden in jedem Modus Messungen in dem ersten Zustand und anschließend Messungen in dem zweiten Zustand durchgeführt. Hiernach wird für jeden Modus eine um die ermittelte Offsetspannung korrigierte Hallspanspannung berechnet. Anschließend wird eine Addition der Hallspannungen der vier Moden unter Berücksichtigung der Vorzeichen durchgeführt. Es versteht sich, dass sich alternativ auch ein arithmetischer Mittelwert aus den Beträgen der vier Hallspannungen berechnen lässt.

In einer bevorzugten Ausführungsform ist der erste Anschlusskontakt bis einschließlich des fünften Anschlusskontakts auf einer Geraden angeordnet. Ferner ist es bevorzugt, den Hallsensor als vertikalen Hallsensor auszubilden.

Gemäß einer anderen Weiterbildung weist der Hallsensor ein Wannengebiet mit einem ersten Leitfähigkeitstyp auf, wobei das Wannengebiet sämtliche Anschlusskontakte umfasst und zwischen zwei benachbarten Anschlusskontakten ein vorgegebener Abstand ausgebildet ist. Vorzugsweise sind die Abstände zwischen den Anschlusskontakten im Wesentlichen gleich groß. Es ist vorteilhaft, dass das Wannengebiet zwischen der Wannengrenze und dem ersten Anschlusskontakt und zwischen der Wannengrenze und dem fünften Anschlusskontakt ebenfalls den vorgegebenen Abstand aufweist. Es sei angemerkt, dass es in einer alternativen Ausführungsform hinreichend ist, wenn der Abstand zwischen dem zweiten Anschlusskontakt und dem dritten Anschlusskontakt Im wesentlichen gleich groß ist wie der Abstand zwischen dem dritten Anschlusskontakt und dem vierten Anschlusskontakt. Hierbei ist der Abstand zwischen dem ersten Anschlusskontakt und dem zweiten Anschlusskontakt im Wesentlichen gleich groß zu dem Abstand zwischen dem vierten Anschlusskontakt und dem fünften Anschlusskontakt. In der hierdurch vorliegenden Ausführungsform ist der Abstand zur Wannengrenze vorzugsweise mindestens so groß wie der kleinste der jeweiligen Abstände der Kontakte zueinander zu wählen.

In einer bevorzugten Weiterbildung Ist der Hallsensor zusammen mit einer Integrierten Schaltung in einem einzigen Halbleiterkörper angeordnet. Hierdurch lässt sich der Hallsensor als Teil der integrierten Schaltung ausbilden und mit einer in einer Wirkverbindung stehenden Ansteuerschaltung und Auswerteschaltung monolithisch integrieren. Es sei angemerkt, dass unter dem Begriff Wirkverbindung unter anderem auch eine elektrische Verbindung zwischen der integrierten Schaltung und dem Magnetfeldsensor verstanden wird. Weiterhin ist es bevorzugt, den Hallsensor und die Integrierte Schaltung in einem einzigen gemeinsamen Gehäuse anzuordnen.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckungen sind nicht maßstäblich und weisen, sofern nicht anders angegeben, auch keine ableitbare geometrische Relation zueinander auf. Darin zeigen die:
- Figur 1: eine schematische Draufsicht auf eine erfindungsgemäße Ausführungsform eines Magnetfeldsensors,
- Figur 2: einen schematischen Querschnitt entlang einer Linie II der Ausführungsform der Figur 1,
- Figur 3: eine schematische Draufsicht auf eine weitere Ausführungsform eines Magnetfeldsensors.

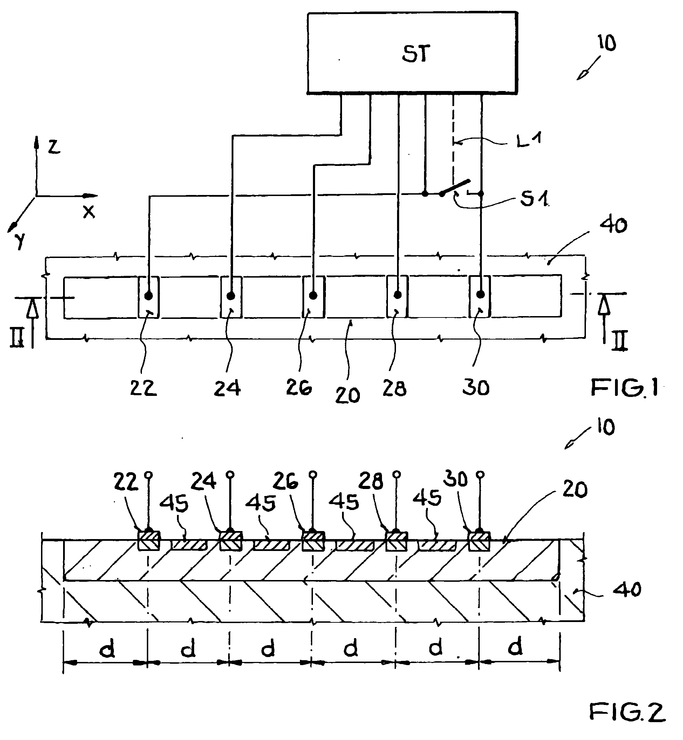

Die Abbildung der Figur 1 zeigt eine Ausführungsform eines erfindungsgemäßen Magnetfeldsensors 10, aufweisend einen vorzugsweise vertikal ausgebildeten Hallsensor 20, mit einem ersten Anschlusskontakt 22, einem zweiten Anschlusskontakt 24, einem dritten Anschlusskontakt 26, einem vierten Anschlusskontakt 28 und einem fünften Anschusskontakt 30, wobei alle Anschlusskontakte mit einer Steuerungseinheit ST verschaltet sind. Hierbei ist der erste Anschlusskontakt 22 bis einschließlich des fünften Anschlusskontakts 30 vorzugsweise auf einer Geraden angeordnet. Zwischen dem ersten Anschlusskontakt 22 und dem fünften Anschlusskontakt 30 ist ein erster Schalter S1 zwischengeschaltet. Der erste Schalter S1 weist einen Steuereingang, der mit einer Leitung L1 mit der Steuerungseinheit ST verschaltet ist.

Mittels der Steuerungseinheit ST wird in einem ersten Zustand die Verbindung zwischen dem ersten Anschlusskontakt 22 und dem fünften Anschlusskontakt 30 getrennt und in einem zweiten Zustand geschlossen. Es sei angemerkt, dass die Anschlusskontakte 22 bis 30 des vertikalen Hallsensors 20 in der einzeichneten x-z Ebene an der Oberfläche eines Halbleiterkörpers ausgebildet sind. Die zu messenden magnetischen Feldlinien B zeigen In eine positive oder negative z-Richtung. Mittels der Steuerungseinheit ST werden die Spannungen bzw. Ströme an ausgewählten Anschlusskontakten gemessen, während andere ausgewählte Anschlusskontakte mit einer Spannung beaufschlagt werden. Insgesamt lassen sich durch eine Permutation mittels der Steuerungseinheit ST In dem ersten Zustand als auch in dem zweiten Zustand jeweils vier unterschiedliche Anschlussbelegungen ausbilden. Hierdurch lässt sich in den vier verschiedenen Moden jeweils eine um einen Offset korrigierte Hallspannung bestimmen.

In der Figur 2 ist ein Querschnitt entlang einer Linie II der erfindungsgemäßen Ausführungsform der Figur 1 dargestellt. Im Folgenden werden nur die Unterschiede zu der Ausführungsform, abgebildet in der Figur 1, erläutert. Unmittelbar unterhalb des ersten Anschlusskontaktes 22 bis einschließlich des fünften Anschlusskontaktes 30 ist jeweils ein hochdotiertes n-Kontaktgebiet ausgebildet, um die einzelnen Anschlusskontakte 22 bis 30 niederohmig an ein niedrig dotiertes n-Wannengebiet 40 anzuschließen. Das n-Wannengebiet 40 ist in dem Halbleiterkörper ausgebildet. Zwischen den einzelnen n-Kontaktgebieten ist jeweils ein Isolationsgebiet 45, vorzugsweise aus Oxid oder einer p+-Diffusion bestehend, ausgebildet. Der Halbleiterkörper ist vorzugsweise als p-Substrat ausgebildet. Vorzugsweise weist das n-Wannengebiet 40 eine Phosphordotierung auf, während die n-Kontaktgebiete vorzugsweise eine Arsendotierung aufweisen, wobei die Konzentration der Dotierung der Kontaktgebiete oberhalb der Dotierung der Wannen ist. Demhingegen weist das p-Substrat eine Bordotierung auf. Die Anschlusskontakte 22 bis 30 sind jeweils durch einen Abstand d zueinander beabstandet. Des Weiteren ist zwischen dem ersten Anschlusskontakt 22 und dem Rand des n-Wannengebiets 40 und zwischen dem fünften Anschlusskontakt und dem Rand des n-Wannengeblets 40 jeweils auch ein Abstand d ausgebildet. Gemäß der dargestellten Ausführungsform weist die Richtung des zu messenden Magnetfeldes In die positive oder negative z-Richtung, d.h. aus der Zeichenebene hinein oder heraus.

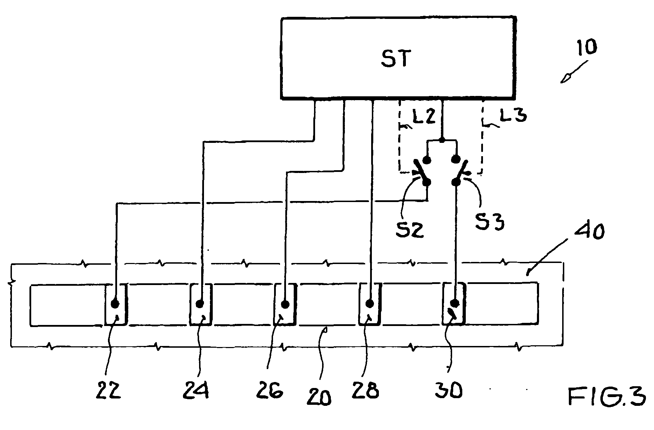

In der Figur 3 Ist eine schematische Draufsicht auf eine weitere Ausführungsform eines Magnetfeldsensors dargestellt. Nachfolgend werden nur die Unterschiede zu der Ausführungsform dargestellt in der Figur 1 erläutert. Demgemäß wird der erste Schalter S1 nunmehr durch einen zweiten Schalter S2 und einen dritten Schalter S3 ersetzt, wobei der zweite Schalter S2 und der dritte Schalter S3 miteinander in Serie verschaltet sind und der zweite Schalter S2 mit einer zweiten Leitung L2 mit einem Steuerungseingang mit der Steuerungseinheit ST und der dritte Schalter S3 mit einer dritten Leitung L3 mit einem Steuerungseingang mit der Steuerungseinheit ST verschaltet sind. Bei den Messungen In dem ersten Zustand wird durch die Steuerungseinheit entweder der zweite Schalter geschlossen oder der dritte Schalter geschlossen und hierdurch entweder der erste Anschlusskontakt 22 oder der fünfte Anschlusskontakt 30 mit der Steuerungseinheit verbünden. Ein Vorteil der Ausführung ist, dass in dem zweiten Zustand, in dem der zweite Schalter S2 und der dritte Schalter S3 geschlossen sind, die Schalterwiderstände des zweiten Schalters S2 und des dritten Schalters S3 In der jeweiligen Leitung zum ersten Anschlusskontakt 22 und zum fünften Anschlusskontakt 30 symmetrisch ausgebildet sind.

## Patentansprüche

1. Magnetfeldsensor (10) aufweisend,
- einen einzelnen vertikalen in einer elektrisch isolierten Wanne ausgebildeten Hallsensor (20) mit einem ersten Anschlusskontakt (22) und mit einem zweiten Anschlusskontakt (24) und mit einem dritten Anschlusskontakt (26) und mit einem vierten Anschlusskontakt (28) und mit einem fünften Anschlusskontakt (30), und
alle Anschlusskontakte in einer Reihe angeordnet, wobei der erste Anschlusskontakt des Hallsensors als Anfangskontakt und der fünfte Anschlusskontakt als Endkontakt der Reihe ausgebildet ist, und zwischen dem ersten Anschlusskontakt (22) und dem fünften Anschlusskontakt (30) ein erster Schalter (S1) mit einem Steuerungseingang vorgesehen ist und der erste Schalter (S1) den ersten Anschlusskontakt (22) mit dem fünften Anschlusskontakt (30) verbindet oder voneinander trennt, und eine Steuerungseinheit (ST) vorgesehen ist und die Steuerungseinheit (ST) mit dem Steuerungseingang des ersten Schalters (S1) verbunden ist, wobei die Steuerungseinheit (ST) eingerichtet ist, zur Bestimmung der Offsetspannung in einem ersten Zustand mittels des ersten Schalters (S1) den ersten Anschlusskontakt (22) von dem fünften Anschlusskontakt (30) zu trennen und in einem zweiten Zustand zur Messung einer mit der Offsetspannung beaufschlagten Hallspannung mittels des Schalters (S1) den ersten Anschlusskontakt (22) mit dem fünften Anschlusskontakt (30) zu verbinden.

2. Magnetfeldsensor (10) nach Anspruch 1, **dadurch gekennzeichnet, dass** der erste Schalter (S1) aus einem zweiten Schalter (S2) und einem dritten Schalter (S3) besteht und der zweite Schalter (S2) und der dritte Schalter (S3) miteinander in Serie verschaltet sind und der zweite Schalter (S2) mit einem Steuerungseingang mit der Steuerungseinheit (ST) und der dritte Schalter (S3) mit einem Steuerungseingang mit der Steuerungseinheit (ST) verschaltet sind.

3. Magnetfeldsensor (10) nach Anspruch 1 oder Anspruch 2, **dadurch gekennzeichnet, dass** der erste Anschlusskontakt (22) und der zweite Anschlusskontakt (24) und der dritte Anschlusskontakt (26) und der vierte Anschlusskontakt (28) und der fünfte Anschlusskontakt (30) mit der Steuerungseinheit (ST) verschaltet sind.

4. Magnetfeldsensor (10) nach einem der vorstehenden Ansprüche, **dadurch gekennzeichnet, dass** die Steuerungseinheit (ST) eingerichtet ist, zur Bestimmung der Offsetspannung in einem ersten Zustand mittels des zweiten Schalters (S2) und des dritten Schalters (S3) den ersten Anschlusskontakt (22) von dem fünften Anschlusskontakt (30) zu trennen und in einem zweiten Zustand zur Messung einer mit der Offsetspannung beaufschlagten Hallspannung mittels des Schalters (S1) den ersten Anschlusskontakt (22) mit dem fünften Anschlusskontakt (30) zu verbinden.

5. Magnetfeldsensor (10) nach einem der vorstehenden Ansprüche, **dadurch gekennzeichnet, dass** der erste Anschlusskontakt (22) bis einschließlich des fünften Anschlusskontakts (30) auf einer Geraden angeordnet sind.

6. Magnetfeldsensor (10) nach einem der vorstehenden Ansprüche, **dadurch gekennzeichnet, dass** der Hallsensor (20) als vertikaler Hallsensor ausgebildet ist.

7. Magnetfeldsensor (10) nach einem der vorstehenden Ansprüche, **dadurch gekennzeichnet, dass** der Hallsensor (20) ein Wannengebiet mit einem ersten Leitfähigkeitstyp aufweist und das Wannengebiet sämtliche Anschlusskontakte umfasst, wobei zwischen zwei benachbarten Anschlusskontakten ein Abstand (d) ausgebildet ist und das Wannengebiet zwischen der Wannengrenze und dem ersten Anschlusskontakt (22) und zwischen der Wannengrenze und dem fünften Anschlusskontakt (30) den Abstand (d) aufweist.

8. Magnetfeldsensor (10) nach einem der vorstehenden Ansprüche, **dadurch gekennzeichnet, dass** alle Anschlusskontakte (22, 24, 26, 28, 30) in einer Reihe angeordnet sind.

9. Magnetfeldsensor (10) nach einem der vorstehenden Ansprüche, **dadurch gekennzeichnet, dass** der erste Anschlusskontakt (22) und der fünfte Anschlusskontakt (30) jeweils außenliegenden Anschlusskontakte ausbilden, sodass die weiteren Anschlusskontakte zwischen dem ersten Anschlusskontakt (22) und dem fünften Anschlusskontakt (30) ausgebildet sind.

10. Magnetfeldsensor (10) nach einem der vorstehenden Ansprüche, **dadurch gekennzeichnet, dass** der Hallsensor (20) in einem Halbleiterkörper angeordnet ist und auf dem Halbleiterkörper eine integrierte Schaltung ausgebildet ist.

11. Magnetfeldsensor (10) nach Anspruch 10, **dadurch gekennzeichnet, dass** der Hallsensor (20) und die integrierte Schaltung elektrisch verbunden und in einem einzigen gemeinsamen Gehäuse angeordnet sind.

12. Verfahren zur Bestimmung und Korrektur einer Offsetspannung eines Magnetfeldsensors (10), aufweisend einen einzelnen vertikalen in einer elektrisch isolierten Wanne ausgebildeten Hallsensor (20) mit einem ersten Anschlusskontakt (22) und mit einem zweiten Anschlusskontakt (24) und mit einem dritten Anschlusskontakt (26) und mit einem vierten Anschlusskontakt (28) und mit einem fünften Anschlusskontakt (30), und alle Anschlusskontakte in einer Reihe angeordnet, wobei der erste Anschlusskontakt des Hallsensors als Anfangskontakt und der fünfte Anschlusskontakt als Endkontakt der Reihe ausgebildet ist, und
eine Steuerungseinheit (ST) und ein erster Schalter (S1) mit einem Steuerungseingang zwischen dem ersten Anschlusskontakt (22) und dem fünften Anschlusskontakt (30) vorgesehen ist und in einem ersten Zustand mittels der Steuerungseinheit (ST) der Steuerungseingang des Schalters (S1) angesteuert wird und die Offsetspannung des Hallsensors (20) bestimmt wird und mittels des ersten Schalters (S1) der erste Anschlusskontakt (22) von dem fünften Anschlusskontakt (30) getrennt wird und in einem zweiten Zustand mittels des ersten Schalters (S1) der erste Anschlusskontakt (22) mit dem fünften Anschlusskontakt (30) verbunden wird und eine mit der Offsetspannung beaufschlagte Hallspannung gemessen wird und die gemessene Hallspannung um die Offsetspannung korrigiert wird.

13. Verfahren nach Anspruch 12, **dadurch gekennzeichnet, dass** in dem ersten Zustand die Widerstände jeweils zwischen zwei benachbarten Anschlusskontakten bestimmt werden und zur Bestimmung der Widerstände die Anschlusskontakte (22, 24, 26, 28, 30) mit unterschiedlichen Spannungshöhen beaufschlagt werden.

14. Verfahren nach Anspruch 13, **dadurch gekennzeichnet, dass** aus den ermittelten Widerstandswerten die der Hallspannung überlagerte Offsetspannung bestimmt wird.

15. Verfahren nach Anspruch 14, **dadurch gekennzeichnet, dass** mittels einer Umschaltmethode vier um die jeweilige Offsetspannung korrigierte Hallspannungen ermittelt werden und aus den vier Hallspannungen eine mittlere Hallspannung bestimmt wird.

## Claims

1. Magnetic field sensor (10) comprising:
- a single Hall sensor (20), which is formed vertically in an electrically insulated trough, with a first terminal contact (22), a second terminal contact (24), a third terminal contact (26), a fourth terminal contact (28) and a fifth terminal contact (30),
all terminal contacts being arranged in a row, wherein the first terminal contact of the Hall sensor is formed as an initial contact and the fifth terminal contact as a final contact of the row, and
a first switch (S1) with a control input is provided between the first terminal contact (22) and the fifth terminal contact (30), the first switch (S1) connecting the first terminal contact (22) with the fifth terminal contact (30) or separating them from one another,
and a control unit (ST), which is connected with the control input of the first switch (S1), is provided, wherein the control unit (ST) is arranged, for determination of the offset voltage, in a first state to separate the first terminal contact (22) from the fifth terminal contact (30) by means of the first switch (S1) and, for measurement of a Hall voltage which is influenced by the offset voltage, in a second state to connect the first terminal contact (22) with the fifth terminal contact (30) by means of the switch (S1).

2. Magnetic field sensor (10) according to claim 1, **characterised in that** the first switch (S1) consists of a second switch (S2) and a third switch (S3), the second switch (S2) and the third switch (S3) are connected with one another in series, the second switch (S2) is connected by a control input with the control unit (ST) and the third switch (S3) is connected by a control input with the control unit (ST).

3. Magnetic field sensor (10) according to claim 1 or claim 2, **characterised in that** the first terminal contact (22), the second terminal contact (24), the third terminal contact (26), the fourth terminal contact (28) and the fifth terminal contact (30) are connected with the control unit (ST).

4. Magnetic field sensor (10) according to any one of the preceding claims, **characterised in that** the control unit (ST) is arranged, for determination of the offset voltage, in a first state to separate the first terminal contact (22) from the fifth terminal contact (30) by means of the second switch (S2) and the third switch (S3) and, for measurement of a Hall voltage influenced by the offset voltage, in a second state to connect the first terminal contact (22) with the fifth terminal contact (30) by means of the switch (S1).

5. Magnetic field sensor (10) according to any one of the preceding claims, **characterised in that** the first terminal contact (22) to the fifth terminal contact (30) inclusive are arranged on a straight line.

6. Magnetic field sensor (10) according to any one of the preceding claims, **characterised in that** the Hall sensor (20) is constructed as a vertical Hall sensor.

7. Magnetic field sensor (10) according to any one of the preceding claims, **characterised in that** the Hall sensor (20) has a trough region with a first conductivity type and the trough region surrounds all terminal contacts, wherein a spacing (d) is formed between two adjacent terminal contacts and the trough region between the trough boundary and the first terminal contact (22) and between the trough boundary and the fifth terminal contact (30) has the spacing (d).

8. Magnetic field sensor (10) according to any one of the preceding claims, **characterised in that** all terminal contacts (22, 24, 26, 28, 30) are arranged in a row.

9. Magnetic field sensor (10) according to any one of the preceding claims, **characterised in that** the first terminal contact (22) and the fifth terminal contact (30) respectively form outwardly disposed terminal contacts so that the further terminal contacts are formed between the first terminal contact (22) and the fifth terminal contact (30).

10. Magnetic field sensor (10) according to any one of the preceding claims, **characterised in that** the Hall sensor (20) is arranged in a semiconductor body and an integrated circuit is formed on the semiconductor body.

11. Magnetic field sensor (10) according to claim 10, **characterised in that** the Hall sensor (20) and the integrated circuit are electrically connected and arranged in a single common housing.

12. Method for determination and correction of an offset voltage of a magnetic field sensor (10), comprising a single Hall sensor (20), which is formed vertically in an electrically insulated trough, with a first terminal contact (22), a second terminal contact (24), a third terminal contact (26), a fourth terminal contact (28) and a fifth terminal contact (30), all terminal contacts being arranged in a row, wherein the first terminal contact of the Hall sensor is formed as an initial contact and the fifth terminal contact as a final contact of the row, and a control unit (ST) and a first switch (S1) with a control input are provided, the switch being between the first terminal contact (22) and the fifth terminal contact (30) and, in a first state, the control input of the switch (S1) is activated by means of the control unit (ST), the offset voltage of the Hall sensor (20) is determined and by means of the first switch (S1) the first terminal contact (22) is separated from the fifth terminal contact (30) and, in a second state, the first terminal contact (22) is connected by means of the first switch (S1) with the fifth terminal contact (30), a Hall voltage influenced by the offset voltage is measured and the measured Hall voltage is corrected by the offset voltage.

13. Method according to claim 12, **characterised in that** in the first state the resistances respectively between two adjacent terminal contacts are determined and for determination of the resistances the terminal contacts (22, 24, 26, 28, 30) are acted on by different voltage levels.

14. Method according to claim 13, **characterised in that** the offset voltage superimposed on the Hall voltage is determined from the ascertained resistance values.

15. Method according to claim 14, **characterised in that** four Hall voltages corrected by the respective offset voltage are determined by means of a switching-over method and a mean Hall voltage is determined from the four Hall voltages.

## Revendications

1. Capteur de champ magnétique (10) présentant :
- un unique capteur de Hall vertical (20) formé dans une cuvette électriquement isolée avec un premier contact de raccordement (22) et avec un deuxième contact de raccordement (24) et avec un troisième contact de raccordement (26) et avec un quatrième contact de raccordement (28) et avec un cinquième contact de raccordement (30), et
tous les contacts de raccordement sont agencés en une rangée, le premier contact de raccordement du capteur de Hall étant réalisé en tant que contact initial et le cinquième contact de raccordement étant réalisé en tant que contact final de la rangée, et
il est prévu entre le premier contact de raccordement (22) et le cinquième contact de raccordement (30) un premier interrupteur (S1) avec une entrée de commande et le premier interrupteur (S1) relie le premier contact de raccordement (22) au cinquième contact de raccordement (30) ou les sépare l'un de l'autre et il est prévu une unité de commande (ST) et l'unité de commande (ST) est reliée à l'entrée de commande du premier interrupteur (S1),
l'unité de commande (ST) étant conçue, pour la détermination de la tension offset, pour séparer dans un premier état au moyen du premier interrupteur (S1) le premier contact de raccordement (22) du cinquième contact de raccordement (30) et pour relier dans un deuxième état, pour la mesure d'une tension de Hall soumise à la tension offset, au moyen de l'interrupteur (S1) le premier contact de raccordement (22) au cinquième contact de raccordement (30).

2. Capteur de champ magnétique (10) selon la revendication 1, **caractérisé en ce que** le premier interrupteur (S1) se compose d'un deuxième interrupteur (S2) et d'un troisième interrupteur (S3) et le deuxième interrupteur (S2) et le troisième interrupteur (S3) sont connectés l'un à l'autre en série et le deuxième interrupteur (S2) est connecté avec une entrée de commande à l'unité de commande (ST) et le troisième interrupteur (S3) est connecté avec une entrée de commande à l'unité de commande (ST).

3. Capteur de champ magnétique (10) selon la revendication 1 ou la revendication 2, **caractérisé en ce que** le premier contact de raccordement (22) et le deuxième contact de raccordement (24) et le troisième contact de raccordement (26) et le quatrième contact de raccordement (28) et le cinquième contact de raccordement (30) sont connectés à l'unité de commande (ST).

4. Capteur de champ magnétique (10) selon l'une quelconque des revendications précédentes, **caractérisé en ce que** l'unité de commande (ST) est conçue, pour la détermination de la tension offset, pour séparer dans un premier état au moyen du deuxième interrupteur (S2) et du troisième interrupteur (S3) le premier contact de raccordement (22) du cinquième contact de raccordement (30) et pour relier dans un deuxième état, au moyen de l'interrupteur (S1), le premier contact de raccordement (22) au cinquième contact de raccordement (30), pour la mesure d'une tension de Hall soumise à la tension offset.

5. Capteur de champ magnétique (10) selon l'une quelconque des revendications précédentes, **caractérisé en ce que** le premier contact de raccordement (22) jusqu'au cinquième contact de raccordement (30) inclus sont disposés sur une ligne droite.

6. Capteur de champ magnétique (10) selon l'une quelconque des revendications précédentes, **caractérisé en ce que** le capteur de Hall (20) est formé par un capteur de Hall vertical.

7. Capteur de champ magnétique (10) selon l'une quelconque des revendications précédentes, **caractérisé en ce que** le capteur de Hall présente une zone de cuvette avec un premier type de conductibilité et la zone de cuvette comprend tous les contacts de raccordement, dans lequel une distance (d) est formée entre deux contacts de raccordement voisins et la zone de cuvette présente la distance (d) entre la limite de la cuvette et le premier contact de raccordement (22) et entre la limite de la cuvette et le cinquième contact de raccordement (30).

8. Capteur de champ magnétique (10) selon l'une quelconque des revendications précédentes, **caractérisé en ce que** tous les contacts de raccordement (22, 24, 26, 28, 30) sont disposés en une rangée.

9. Capteur de champ magnétique (10) selon l'une quelconque des revendications précédentes, **caractérisé en ce que** le premier contact de raccordement (22) et le cinquième contact de raccordement (30) forment à chaque fois des contacts de raccordement situés extérieurement, de telle manière que les autres contacts de raccordement soient disposés entre le premier contact de raccordement (22) et le cinquième contact de raccordement (30).

10. Capteur de champ magnétique (10) selon l'une quelconque des revendications précédentes, **caractérisé en ce que** le capteur de Hall (20) est disposé dans un corps semi-conducteur et un circuit intégré est formé sur le corps semi-conducteur.

11. Capteur de champ magnétique (10) selon la revendication 10, **caractérisé en ce que** le capteur de Hall (20) et le circuit intégré sont électriquement reliés et sont disposés dans un boîtier unique commun.

12. Procédé pour la détermination et la correction d'une tension offset d'un capteur de champ magnétique (10), présentant un unique capteur de Hall vertical (20) formé dans une cuvette électriquement isolée avec un premier contact de raccordement (22) et avec un deuxième contact de raccordement (24) et avec un troisième contact de raccordement (26) et avec un quatrième contact de raccordement (28) et avec un cinquième contact de raccordement (30), et
tous les contacts de raccordement sont agencés en une rangée, dans lequel le premier contact de raccordement du capteur de Hall est réalisé en tant que contact initial et le cinquième contact de raccordement est réalisé en tant que contact final de la rangée, et
il est prévu une unité de commande (ST) et un premier interrupteur (S1) avec une entrée de commande entre le premier contact de raccordement (22) et le cinquième contact de raccordement (30) et, dans un premier état, on commande l'entrée de commande de l'interrupteur (S1) au moyen de l'unité de commande (ST) et on détermine la tension offset du capteur de Hall (20) et on sépare au moyen du premier interrupteur (S1) le premier contact de raccordement (22) du cinquième contact de raccordement (30) et, dans un deuxième état, on relie au moyen du premier interrupteur (S1) le premier contact de raccordement (22) au cinquième contact de raccordement (30) et on mesure une tension de Hall soumise à la tension offset et on corrige la tension de Hall mesurée de la tension offset.

13. Procédé selon la revendication 12, **caractérisé en ce que**, dans le premier état, on détermine les résistances respectivement entre deux contacts de raccordement voisins et, pour la détermination des résistances, on soumet les contacts de raccordement (22, 24, 26, 28, 30) à différents niveaux de tension.

14. Procédé selon la revendication 13, **caractérisé en ce que** l'on détermine, à partir des valeurs de résistance déterminées, la tension offset superposée à la tension de Hall.

15. Procédé selon la revendication 14, **caractérisé en ce que** l'on détermine, par une méthode de commutation, quatre tensions de Hall corrigées de la tension offset respective et on détermine à partir des quatre tensions de Hall une tension de Hall moyenne.
